# EUROPEAN PATENT SPECIFICATION

(11) **EP 2 755 322 B1**
(45) Date of publication and mention of the grant of the patent: **15.08.2018**
(21) Application number: 14150666.7
(22) Date of filing: 09.01.2014
(51) Int. Cl.: H03F 1/02, H03F 3/181, H03F 1/52, H03F 3/72

(54) **An audio amplifier**
Audioverstärker
Un amplificateur audio

(30) Priority: 14.01.2013 GB 201300553
(43) Date of publication of application: 16.07.2014
(73) Proprietor: Eaton Intelligent Power Limited, 4 Dublin (IE)
(72) Inventor: Mason, Steve, Stratford upon Avon, Warwickshire CV37 9NB (GB)
(74) Representative: Ashton, Gareth Mark

(56) References cited:
- WO-A1-2012/028017
- US-A- 4 258 332
- US-A- 4 683 591
- US-A1- 2007 018 719
- US-A1- 2009 051 423
- US-B1- 7 898 324

## Description

The present invention relates to an audio amplifier.

Known audio amplifiers are often a compromise between audio fidelity and power consumption. In particular, class A amplifiers give low distortion but typically only output 50% of the power that they require to operate, whereas class D amplifiers are much more power efficient but often introduce large amounts of distortion.

Some class D amplifiers are capable of minimising the distortion that they introduce to the signal, although these typically use a high frequency switching stage followed by a carefully designed filter stage to remove the high-frequency distortion introduced by the switching, and can be expensive.

US 2007/0018719 discloses audio power amplifier circuits that are arranged to operate in either a class AB or a class D operating mode. The audio power amplifier circuits are operated in class AB mode when the input signal level is in a defined operating range, and in class D mode when the input signal level is above a maximum signal level.

One application for audio amplifiers is in combined Public Announcement and General Alarm (PA/GA) systems, where single speaker device(s) are designed to output both speech audio and alarm audio. However, audio amplifiers which are designed to give good linearity for speech audio can suffer from overheating when amplifying alarm audio that is at maximum volume.

It is therefore an aim of the invention to provide an improved audio amplifier.

According to a first aspect of the invention, there is provided an audio amplifier for amplifying an audio signal, the audio amplifier comprising a first amplifier, a second amplifier, and a selector control, wherein the first amplifier and the second amplifier are different types of amplifier to one another, and wherein the selector control is configured to select which one of the first amplifier and the second amplifier is used to amplify the audio signal. The selection is based upon an indicator signal received at the selector control that specifies a type of audio carried by the audio signal, wherein the selector control is configured to select the first amplifier for amplifying the audio signal when the indicator signal specifies that the type of the audio is voice audio, and wherein the selector control is configured to select the second amplifier for amplifying the audio signal when the indicator signal specifies that the type of the audio is alarm audio.

The present invention recognises that different types of audio may be more suited to different types of amplifiers, and accordingly provides selection between two different amplifiers according to the type of audio that is being amplified. Speech audio requires good linearity of amplification so that fluctuations in voice volume are accurately represented, whereas alarm audio requires high efficiency of amplification in order to avoid overheating of the amplifier.

Advantageously, the first amplifier may be a linear amplifier, and the second amplifier may be a non-linear amplifier. Accordingly, the linear amplifier can be reserved for audio types that require a high linearity for low distortion at the output, and the non-linear amplifier can be used for other audio types or situations where linearity is less important.

The first amplifier may be a class A or AB amplifier to provide low-distortion amplification, and the second amplifier may be a switched mode amplifier, such as a class D amplifier, to provide power efficient amplification. Power efficiency is considered to be the amount of power that the audio amplifier outputs relative to the amount of power that the audio amplifier dissipates within its circuitry.

The audio amplifier may comprise an audio signal input for receiving the audio signal, and an input selector. The input selector may have an input connected to the audio signal input, an output connected to an input of the first amplifier, and an output connected to an input of the second amplifier. The input selector is switchable by the selector control to divert the audio signal to either the first amplifier or the second amplifier.

Accordingly, the audio signal may be received at a single input and then diverted to one amplifier or the other amplifier depending upon the audio type, so that only one of the two amplifiers is used to amplify the audio. The other of the two amplifiers may be powered down to save power.

Alternatively, the audio may always be delivered to the inputs of both of the first and second amplifiers, and the audio amplifier may comprise a power controller that is switchable by the selector control to either power the first amplifier or the second amplifier, so that the audio signal is only amplified by the appropriate amplifier.

The audio amplifier may comprise an output selector having an input connected to an output of the first amplifier, an input connected to an output of the second amplifier, and an output connected to an audio signal output of the audio amplifier. The output selector may be controllable by the selector control to divert either an amplified audio signal from the output of the first amplifier or an amplified audio signal from the output of the second amplifier to the output of the audio signal amplifier. Accordingly, a single output from the audio amplifier may be provided for connecting to speaker devices to generate sound.

The indicator signal may be encoded together with the audio signal in a digital signal so that the indicator signal does not require a separate input at the audio amplifier.

According to a second aspect of the invention, there is provided a combined public announcement and alarm system, comprising the audio amplifier of the first aspect of the invention, at least one microphone station, at least one alarm station, and a switch station connected to the microphone and alarm stations. The switch station is configured to send an audio signal comprising either voice audio from one of the microphone stations or alarm audio based on one of the alarm stations to the audio amplifier.

The switch station may be configured to send an indicator signal to the audio amplifier based on whether the audio signal sent to the audio amplifier comprises audio from a microphone station or audio based on an alarm station.

At least one of the alarm stations may be alarm initiation stations, and the alarm audio may be generated at the switch station when an alarm initiation signal is received from one or more of the at least one alarm initiation stations.

The combined public announcement and alarm system may comprise field devices that incorporate one of the microphone stations and one of the alarm stations in a common housing. The field device may also comprise a speaker connected to the audio signal output of the audio amplifier.

Preferably, the audio amplifier receives the audio signal from the switch station, and sends amplified audio to multiple speaker devices at multiple respective field stations. Alternatively, the switch station may send the audio signal to multiple audio amplifiers that are integrated within multiple respective field devices.

Embodiments of the invention will now be described with reference to the accompanying drawings, in which:
Fig. 1 shows a schematic diagram of a combined public announcement and alarm system according to an embodiment of the invention; and
Fig. 2 shows a schematic diagram of an alternate audio amplifier suitable for use in the Fig. 1 embodiment.

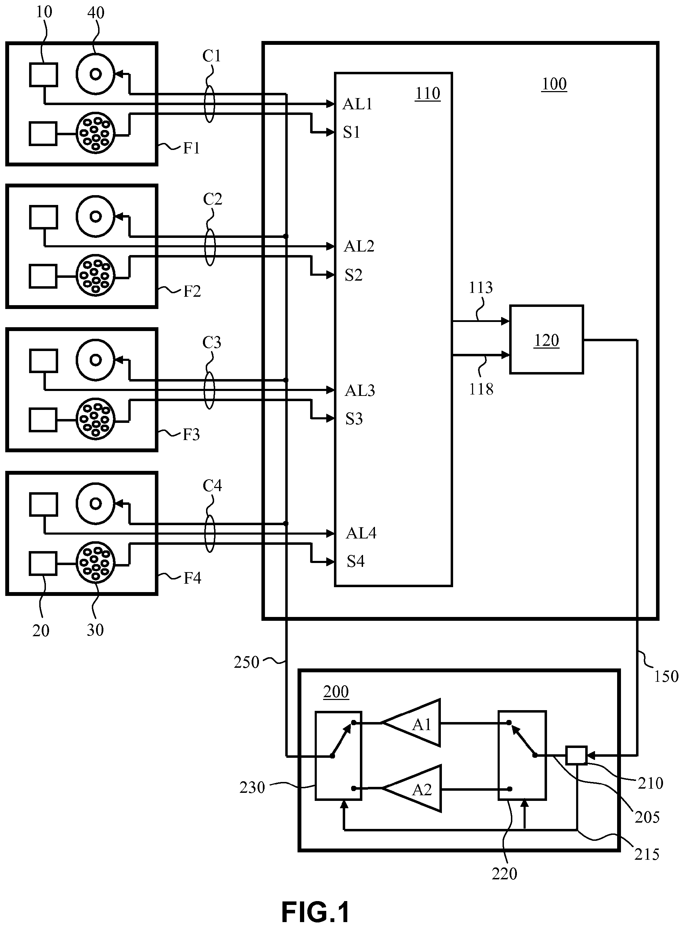

The combined public announcement and alarm system of Fig. 1 comprises four field devices F1 - F4, a switch station 100, and an audio amplifier 200. The field devices F1 - F4 are located in four respective rooms of an oil rig, and are each connected to the switch station 100 by four cables C1 - C4.

Each one of the field devices F1 - F4 comprises an alarm button 10, a microphone button 20, a microphone 30, and a speaker 40. The alarm button 10 may be actuated by a user of the field device to send an alarm initiation signal to the switch station 100, for example in case of a fire or other emergency.

The microphone button 20 may be actuated by a user of the field device to enable the microphone 30 of the field device to send a microphone signal to the switch station 100, the microphone signal including any audio that is detected by the microphone 30.

The speaker 40 is connected to the switch station 100, and reproduces audio that is sent to it from the audio amplifier 200 via the switch station 100. Clearly, it would be possible to implement the speakers separately from the field devices if desired, for example to place the speakers overhead rather than down at the height of the field devices, and/or to provide more speakers than field devices.

The switch station 100 comprises a switching stage 110 that is configured to output an alarm signal 113 in response to receiving an alarm initiation signal at any of the inputs AL1 - AL4, and to output a microphone signal 118 in response to receiving the microphone signal at one of the inputs S1 - S4.

The switch station 100 further comprises an output stage 120 that encodes an audio signal based upon the alarm signal 113 and the microphone signal 118. If the output stage 120 receives an alarm signal 113, then the output stage 120 encodes a digital signal 150 incorporating an audio signal that carries alarm audio, and an indicator signal that the audio is alarm audio, and outputs the digital signal 150. If the output stage 120 receives a microphone signal 118, then the output stage 120 encodes the digital signal 150 to incorporate an audio signal carrying voice audio from the microphone signal and an indicator signal that the audio is voice audio, and outputs the digital signal 150.

The audio amplifier 200 comprises a selector control 210, an input selector 220, a first amplifier A1, a second amplifier A2, and an output selector 230. The selector control 210 is connected to the switch station 100 by a cable, and thereby receives the digital signal 150. The audio amplifier 200 outputs an audio signal 250 to the speakers 40 of the field devices.

The selector control 210 is configured to extract the audio signal and the indicator signal from the digital signal 150. The selector control 210 sends the audio signal 205 to the input selector 220, and sends a switch signal 215 to control switching of the input selector 220 and the output selector 230 based on the indicator signal.

The input selector 220 diverts the audio signal 205 to either the first amplifier A1 or the second amplifier A2, based on the switch signal 215. The first amplifier A1 is a substantially linear class A/B amplifier, and the second amplifier A2 is a non-linear class D amplifier formed of MOSFETS. The output selector 230 selects either the output of the first amplifier A1 or the output of the second amplifier A2 as the output audio signal 250.

If the indicator signal specifies that the audio carried by the audio signal 205 is voice audio, then the selector control 210 switches the input selector 220 to divert the audio signal 205 to the first amplifier A1, using the switch signal 215. The switch signal 215 also switches the output selector 230 to output the output of the first amplifier A1 as the audio signal 250.

If the indicator signal specifies that the audio carried by the audio signal 205 is alarm audio, then the selector control 210 switches the input selector 220 to divert the audio signal 205 to the second amplifier A2, using the switch signal 215. The switch signal 215 also switches the output selector 230 to output the output of the second amplifier A2 as the audio signal 250.

Although the embodiment of Fig. 1 only comprises one audio amplifier 200, it will be understood that multiple audio amplifiers 200 could be implemented in further embodiments, for example by assigning each audio amplifier 200 to a corresponding group of speakers. Clearly, the number of field devices may be increased beyond the four shown in Fig. 1, and may be applied to applications other than rooms on oil rigs, for example rooms or areas in other types of industrial installation. The audio amplifier 200 may be incorporated within the switch station 100.

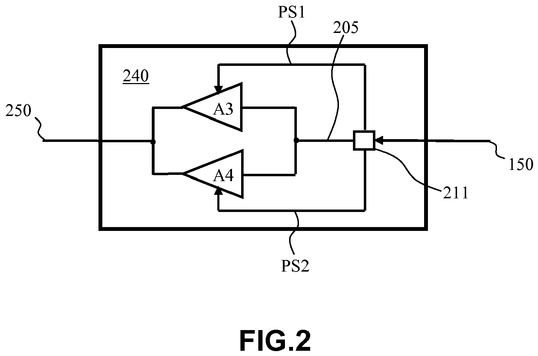

An alternate audio amplifier 240 suitable for use in the Fig. 1 embodiment will now be described with reference to Fig. 2. The audio amplifier 240 comprises a selector control 211, and first and second amplifiers A3 and A4.

The audio amplifier 240 receives the same digital signal 150 as the audio amplifier 200, and the selector control 211 receives the digital signal 150, extracts the audio signal 205, and passes the audio signal 205 to the first and second amplifiers A3 and A4.

The first and second amplifiers A3 and A4 are the same as the first and second amplifiers A1 and A2, except for that the first amplifier A3 has a power control input PS1, and the second amplifier A4 has a power control input PS2. The power control inputs PS1 and PS2 are used by the selector control 211 to activate the first or second amplifiers A3 and A4 by powering them up or powering them down, thereby turning them on or off.

The selector control 211 also extracts the indicator signal from the digital signal 150, and activates either amplifier A3 if the indicator signal specifies that the audio signal carries voice audio, or activates amplifier A4 if the indicator signal specifies that the audio signal carries alarm audio.

The amplified audio signal from either the first amplifier A3 or the second amplifier A4 is output as the audio signal 250.

Although the specific embodiments describe an audio signal and an indicator signal incorporated within a digital signal, in alternate embodiments the audio signal and indicator signal may be supplied to the audio amplifier as separate signals. Furthermore, one or both of the audio signal and the indicator signal may be analogue signals rather than digital signals.

Further alternate embodiments falling within the scope of the appended claims will also be apparent to the skilled person. For example, the audio amplifier may be applied to other situations in which different types of audio require different types of amplification.

## Claims

1. An audio amplifier (200) for amplifying an audio signal (205), the audio amplifier comprising a first amplifier (A1), a second amplifier (A2), and a selector control (210), wherein the first amplifier and the second amplifier are different types of amplifier to one another, and wherein the selector control is configured to select which one of the first amplifier and the second amplifier is used to amplify the audio signal, **characterised in that** the selection is based upon an indicator signal received at the selector control (210) that specifies a type of audio carried by the audio signal, wherein the selector control is configured to select the first amplifier (A1) for amplifying the audio signal when the indicator signal specifies that the type of the audio is voice audio, and wherein the selector control (210) is configured to select the second amplifier (A2) for amplifying the audio signal when the indicator signal specifies that the type of the audio is alarm audio.

2. The audio amplifier of claim 1, wherein the first amplifier (A1) is a linear amplifier, and wherein the second amplifier (A2) is a non-linear amplifier.

3. The audio amplifier of claim 1 or 2, wherein the first amplifier (A1) is a class A or AB amplifier.

4. The audio amplifier of claim 1, 2, or 3, wherein the second amplifier (A2) is a switched mode amplifier.

5. The audio amplifier of claim 4, wherein the second amplifier (A2) is a class D amplifier.

6. The audio amplifier of any preceding claim, further comprising an audio signal input for receiving the audio signal (205), and an input selector (220) having an input connected to the audio signal input, an output connected to an input of the first amplifier (A1), and an output connected to an input of the second amplifier (A2), wherein the input selector (220) is switchable by the selector control (210) to divert the audio signal (205) to either the first amplifier or the second amplifier.

7. The audio amplifier of any preceding claim, further comprising a power controller that is switchable by the selector control (211) to either power the first amplifier or the second amplifier.

8. The audio amplifier of any preceding claim, further comprising an output selector (230) having an input connected to an output of the first amplifier (A1), an input connected to an output of the second amplifier (A2), and an output connected to an audio signal output of the audio amplifier, wherein the output selector (230) is controllable by the selector control (210) to divert either an amplified audio signal (250) from the output of the first amplifier or an amplified audio signal (250) from the output of the second amplifier to the output of the audio signal amplifier.

9. A combined public announcement and alarm system, comprising the audio amplifier (200) of any preceding claim, at least one microphone station (F1, F2, F3, F4), at least one alarm station (F1, F2, F3, F4), and a switch station (100) connected to the microphone and alarm stations, wherein the switch station is configured to send an audio signal (205) comprising either voice audio (118) from one of the microphone stations or alarm audio (113) based on one of the alarm stations to the audio amplifier.

10. The combined public announcement and alarm system of claim 9, wherein the switch station (100) is further configured to send the indicator signal to the audio amplifier (200) based on whether the audio signal sent to the audio amplifier comprises audio (118) from a microphone station or audio (113) based on an alarm station.

11. The combined public announcement and alarm system of claim 9 or 10, wherein the at least one alarm stations (F1, F2, F3, F4) are alarm initiation stations, and wherein the alarm audio is generated at the switch station (100) when an alarm initiation signal is received from one or more of the at least one alarm initiation stations.

12. The combined public announcement and alarm system of claim 9, 10, or 11, comprising field devices (F1, F2, F3, F4) that incorporate one of the microphone stations and one of the alarm stations in a common housing.

13. The combined public announcement and alarm system of claim 12, wherein each field device (F1, F2, F3, F4) comprises a speaker device for converting audio output (250) from the audio amplifier (200) to sound.

## Patentansprüche

1. Audioverstärker (200) zum Verstärken eines Audiosignals (205), wobei der Audioverstärker einen ersten Verstärker (A1), einen zweiten Verstärker (A2) und eine Auswahlsteuerung (210) umfasst, wobei der erste Verstärker und der zweite Verstärker voneinander verschiedene Arten von Verstärker sind, und wobei die Auswahlsteuerung dazu konfiguriert ist auszuwählen, welcher aus dem ersten Verstärker und dem zweiten Verstärker dazu verwendet wird, das Audiosignal zu verstärken, **dadurch gekennzeichnet, dass** die Auswahl auf einem Indikatorsignal basiert, das an der Auswahlsteuerung (210) empfangen wird, das eine Art von Audio festlegt, die von dem Audiosignal getragen wird, wobei die Auswahlsteuerung dazu konfiguriert ist, den ersten Verstärker (A1) zum Verstärken des Audiosignals auszuwählen, wenn das Indikatorsignal festlegt, dass die Art von Audio Sprach-Audio ist, und wobei die Auswahlsteuerung (210) dazu konfiguriert ist, den zweiten Verstärker (A2) zum Verstärken des Audiosignals auszuwählen, wenn das Indikatorsignal festlegt, dass die Art von Audio Alarm-Audio ist.

2. Audioverstärker gemäß Anspruch 1, wobei der erste Verstärker (A1) ein linearer Verstärker ist und wobei der zweite Verstärker (A2) ein nichtlinearer Verstärker ist.

3. Audioverstärker gemäß Anspruch 1 oder 2, wobei der erste Verstärker (A1) ein Klasse-A- oder Klasse-AB-Verstärker ist.

4. Audioverstärker gemäß Anspruch 1, 2 oder 3, wobei der zweite Verstärker (A2) ein Switched-Mode-Verstärker ist.

5. Audioverstärker gemäß Anspruch 4, wobei der zweite Verstärker (A2) ein Klasse-D-Verstärker ist.

6. Audioverstärker gemäß einem der vorhergehenden Ansprüche, ferner umfassend einen Audiosignaleingang zum Empfangen des Audiosignals (205) und eine Eingangsauswahleinrichtung (220), von der ein Eingang mit dem Audiosignaleingang verbunden ist, ein Ausgang mit einem Eingang des ersten Verstärkers (A1) verbunden ist und ein Ausgang mit einem Eingang des zweiten Verstärkers (A2) verbunden ist, wobei die Eingangsauswahleinrichtung (220) von der Auswahlsteuerung (210) schaltbar ist, um das Audiosignal (205) zu entweder dem ersten Verstärker oder dem zweiten Verstärker umzuleiten.

7. Audioverstärker gemäß einem der vorhergehenden Ansprüche, ferner umfassend eine Leistungssteuerung, die von der Auswahlsteuerung (211) schaltbar ist um entweder den ersten Verstärker oder den zweiten Verstärker zu versorgen.

8. Audioverstärker gemäß einem der vorhergehenden Ansprüche, ferner umfassend eine Ausgangsauswahleinrichtung (230), von der ein Eingang mit einem Ausgang des ersten Verstärkers (A1) verbunden ist, ein Eingang mit einem Ausgang des zweiten Verstärkers (A2) verbunden ist und ein Ausgang mit einem Audiosignalausgang des Audioverstärkers verbunden ist, wobei die Ausgangsauswahleinrichtung (230) von der Auswahlsteuerung (210) steuerbar ist, um entweder ein verstärktes Audiosignal (250) von dem Ausgang des ersten Verstärkers oder ein verstärktes Audiosignal (250) von dem Ausgang des zweiten Verstärkers an den Ausgang des Audiosignalverstärkers umzuleiten.

9. Kombiniertes öffentliches Durchsage- und Alarmsystem, umfassend den Audioverstärker (200) gemäß einem der vorhergehenden Ansprüche, mindestens eine Mikrofonstation (F1, F2, F3, F4), mindestens eine Alarmstation (F1, F2, F3, F4) und eine Schaltstation (100), die mit den Mikrophon- und Alarmstationen verbunden ist, wobei die Schaltstation dazu konfiguriert ist, ein Audiosignal (205), das entweder Sprach-Audio (118) von einer der Mikrofonstationen oder Alarm-Audio (113) auf Basis einer der Alarmstationen umfasst, an den Audioverstärker zu senden.

10. Kombiniertes öffentliches Durchsage- und Alarmsystem gemäß Anspruch 9, wobei die Schaltstation (100) ferner dazu konfiguriert ist, das Indikatorsignal auf Basis dessen an den Audioverstärker (200) zu senden, ob das an den Audioverstärker gesendete Audiosignal Audio (118) von einer Mikrofonstation oder Audio (113) auf Basis einer Alarmstation umfasst.

11. Kombiniertes öffentliches Durchsage- und Alarmsystem gemäß Anspruch 9 oder 10, wobei es sich bei der mindestens einen Alarmstation (F1, F2, F3, F4) um Alarm-Auslöse-Stationen handelt und wobei das Alarm-Audio an der Schaltstation (100) erzeugt wird, wenn ein Alarm-Auslöse-Signal von einem oder mehr der mindestens einen Alarm-Auslöse-Stationen empfangen wird.

12. Kombiniertes öffentliches Durchsage- und Alarmsystem gemäß Anspruch 9, 10 oder 11, umfassend Feldgeräte (F1, F2, F3, F4), die eine der Mikrofonstationen und eine der Alarmstationen in einem gemeinsamen Gehäuse enthalten.

13. Kombiniertes öffentliches Durchsage- und Alarmsystem gemäß Anspruch 12, wobei jedes Feldgerät (F1, F2, F3, F4) ein Lautsprechergerät zum Umwandeln einer Audio-Ausgabe (250) von dem Audioverstärker (200) in Klang umfasst.

## Revendications

1. Amplificateur audio (200) destiné à amplifier un signal audio (205), l'amplificateur audio comprenant un premier amplificateur (A1), un deuxième amplificateur (A2), et un sélecteur de commande (210), dans lequel le premier amplificateur et le deuxième amplificateur sont des types d'amplificateur différents l'un de l'autre, et dans lequel le sélecteur de commande est configuré pour sélectionner lequel parmi le premier amplificateur et le deuxième amplificateur est utilisé pour amplifier le signal audio, **caractérisé en ce que** la sélection est basée sur un signal indicateur reçu au niveau du sélecteur de commande (210) qui spécifie un type d'audio porté par le signal audio, dans lequel le sélecteur de commande est configuré pour sélectionner le premier amplificateur (A1) destiné à amplifier le signal audio lorsque le signal indicateur spécifie que le type de l'audio est l'audio vocal, et dans lequel le sélecteur de commande (210) est configuré pour sélectionner le deuxième amplificateur (A2) destiné à amplifier le signal audio lorsque le signal indicateur spécifie que le type de l'audio est l'audio d'alarme.

2. Amplificateur audio selon la revendication 1, dans lequel le premier amplificateur (A1) est un amplificateur linéaire, et dans lequel le deuxième amplificateur (A2) est un amplificateur non-linéaire.

3. Amplificateur audio selon la revendication 1 ou 2, dans lequel le premier amplificateur (A1) est un amplificateur de catégorie A ou AB.

4. Amplificateur audio selon la revendication 1, 2 ou 3, dans lequel le deuxième amplificateur (A2) est un amplificateur à découpage.

5. Amplificateur audio selon la revendication 4, dans lequel le deuxième amplificateur (A2) est un amplificateur de catégorie D.

6. Amplificateur audio selon l'une quelconque des revendications précédentes, comprenant en outre une entrée de signal audio destinée à recevoir le signal audio (205), et un sélecteur d'entrée (220) ayant une entrée connectée à l'entrée de signal audio, une sortie connectée à une entrée du premier amplificateur (A1), et une sortie connectée à une entrée du deuxième amplificateur (A2), dans lequel le sélecteur d'entrée (220) peut être commuté par le sélecteur de commande (210) pour rediriger le signal audio (205) soit vers le premier amplificateur soit vers le deuxième amplificateur.

7. Amplificateur audio selon l'une quelconque des revendications précédentes, comprenant en outre un contrôleur de puissance qui peut être commuté par le sélecteur de commande (211) pour activer soit le premier amplificateur soit le deuxième amplificateur.

8. Amplificateur audio selon l'une quelconque des revendications précédentes, comprenant en outre un sélecteur de sortie (230) présentant une entrée connectée à une sortie du premier amplificateur (A1), une entrée connectée à une sortie du deuxième amplificateur (A2), et une sortie connectée à une sortie de signal audio de l'amplificateur audio, dans lequel le sélecteur de sortie (230) peut être commandé par le sélecteur de commande (210) pour rediriger soit un signal audio (250) amplifié provenant de la sortie du premier amplificateur soit un signal audio (250) amplifié provenant de la sortie du deuxième amplificateur vers la sortie de l'amplificateur de signal audio.

9. Système combiné d'annonce publique et d'alarme, comprenant l'amplificateur audio (200) selon l'une quelconque des revendications précédentes, au moins une station de microphone (F1, F2, F3, F4), au moins une station d'alarme (F1, F2, F3, F4), et une station de commutation (100) connectée aux stations de microphone et d'alarme, dans lequel la station de commutation est configurée pour envoyer un signal audio (205) comprenant soit de l'audio vocal (118) provenant d'une des stations de microphone soit de l'audio d'alarme (113) basé sur une des stations d'alarme de l'amplificateur audio.

10. Système combiné d'annonce publique et d'alarme selon la revendication 9, dans lequel la station de commutation (100) est configurée en outre pour envoyer le signal indicateur à l'amplificateur audio (200) selon que le signal audio envoyé à l'amplificateur audio comprend l'audio (118) provenant d'une station de microphone ou l'audio (113) basé sur une station d'alarme.

11. Système combiné d'annonce publique et d'alarme selon la revendication 9 ou 10, dans lequel la ou les stations d'alarme (F1, F2, F3, F4) sont des stations de déclenchement d'alarme, et dans lequel l'audio alarme est générée à la station de commutation (100) lorsqu'un signal de déclenchement d'alarme est reçu d'une ou de plusieurs de la ou des stations de déclenchement d'alarme.

12. Système combiné d'annonce publique et d'alarme selon la revendication 9, 10 ou 11, comprenant des dispositifs de champ (F1, F2, F3, F4) qui incorporent l'une des stations de microphone et l'une des stations d'alarme dans un logement commun.

13. Système combiné d'annonce publique et d'alarme selon la revendication 12, dans lequel chaque dispositif de champ (F1, F2, F3, F4) comprend un dispositif de haut-parleur destiné à convertir la sortie audio (250) de l'amplificateur audio (200) en son.
